# EUROPEAN PATENT APPLICATION

(11) **EP 2 144 338 A1**
(43) Date of publication of application: **13.01.2010**
(21) Application number: 08012584.2
(22) Date of filing: 11.07.2008
(51) Int. Cl.: H01R 13/631, G01R 1/067

(54) **Coaxial probe**

(71) Applicant: Tyco Electronics Nederland B.V., 5222 AR 's-Hertogenbosch (NL)
(72) Inventor: Tuin, Jacobus, 5684 HC Best (NL)
(74) Representative: Grünecker, Kinkeldey, Stockmair & Schwanhäusser Anwaltssozietät

(57) **Abstract**

The invention relates to a coaxial probe (1) for mating with a coaxial connector (4) which is mounted on a printed circuit board. The coaxial probe (1) comprises a housing (5), an outer contact portion (21) which extends away from the housing (5) in a probe insertion direction (I) and an inner contact portion (17) that is adapted to be moved in the probe insertion direction (I) relative to the housing (5). The housing (5) supports both the inner and outer contact portion (21). To compensate misalignments of the probe the outer contact portion (21) is connected to the housing (5) by an elastically deformable support means (19). The support means (19) is adapted to allow a movement of the outer contact portion (21) relative to the housing (5) in the probe insertion direction.

## Description

The invention relates to a coaxial probe for mating with a coaxial connector, said coaxial connector mounted on a printed circuit board, the coaxial probe comprising:
a housing, an outer contact portion, said outer contact portion extending away from the housing in a probe insertion direction, an inner contact portion, said inner contact portion being adapted to be moved in the probe insertion direction relative to the housing, said housing supporting both the inner and outer contact portion.

Coaxial probes, also known as POGO pins, are used for the in circuit functional testing of printed circuit boards (PCBs). A variety of tip styles and materials are available to suit just about every application. For electrically connecting PCBs to probes coaxial connectors are mounted on PCBs. As the size of integrated circuitry components is reduced and the package density on printed circuit boards is increased, the remaining space for arranging coaxial connectors is reduced. Hence, coaxial connectors are minimized. While testing a PCB assembly many connections between probes and coaxial connectors on the PCB may need to be built up simultaneously. As the coaxial connectors to be probed on the PCB can be very close to each other, it is also required that the probes can be arranged close to each other to allow for testing the PCB assembly within one step.

A probe of the above mentioned nature is disclosed by US 4, 764, 722. This publication describes a coaxial probe with a flexible inner conductor that is housed within a conductive outer sheet. The inner conductor buckles upon the application of an axial load.

A significant shortcoming of prior art probes is that they require precise alignment to mating connectors on printed circuit boards. The allowable misalignment of probes becomes smaller as probes are increasingly miniaturized.

Thus, the problem arises that the allowable misalignment of the probe in relation to the coaxial connector mounted on the printed circuit board prohibits a reliable contact between the probe and the coaxial connector on the PCB.

This problem is solved by connecting the outer contact portion to the housing by an elastically deformable support means, which is adapted to allow a movement of the outer contact portion relative to the housing in the probe insertion direction. This solution allows for a compensation of misalignments of the outer conductor.

In order to allow for a compensation of a misalignment in a direction perpendicular to the insertion direction, the support means can be adapted to allow a deflection of the outer contact portion relative to the housing in a direction substantially perpendicular to the probe insertion direction. The deflection of the outer contact portion can be realized by a pivotable guiding of the outer contact portion within the housing. The outer contact portion can comprise a guiding portion which is arranged within a longitudinal recess in the housing, extending in insertion direction. By providing the guiding portion of the outer conductor with a convex shape, the outer conductor can be rotated relative to the housing. This rotating of the outer conductor results in a movement of the tip of the probe that is substantially perpendicular to insertion direction.

For improving the reliability of the electrical contact between the outer contact portion of the probe and the outer conductor of the mating coaxial connector on the PCB, the housing may comprise a support means exerting a restoring force on the outer conductor. The restoring force may be directed in insertion direction.

The housing may comprise a guiding recess for guiding the outer contact portion in probe insertion direction. The outer contact portion can be connected to the guiding recess by a guiding portion at its proximal end facing the housing which is received within the guiding recess of the housing. The guiding portion can be an integral part of the outer contact portion or a separate guiding element which is connected to the contact portion. To allow for a rotation of the outer contact portion according to a rotation axis that is parallel to the insertion axis the guiding portion may be formed like a cylinder or piston.

In order to allow for pivoting of the outer contact portion according to at least one rotation axis which lies substantially perpendicular to the probe insertion direction the surface of the guiding portion of the outer contact portion which abuts the inner surface of the guiding recess can have a convex shape. The guiding portion can comprise spherical surfaces and, in combination with a cylindrical guiding recess, build up a moveable spherical joint.

In a further advantageous embodiment, the coaxial test probe comprises at least one moveable outer contact body arranged between the support means and the outer contact portion. This contact body can be arranged to guide the restoring force from the support means to the outer contact portion. By arranging the outer contact body on a slanted surface on the outer contact portion, the outer contact body is pushed by the restoring force from the support means against the inner wall of the housing. Thereby, an electrically conductive connection between the outer contact portion and the housing is created. Thus, the housing which serves as outer conductor connects the outer contact portion electrically to the outer conductor of the connecting cable of the probe. The support means which may have a high resistance value does not serve as outer conductor on its own.

If more than one outer contact body is applied for building up the electrical connection, a ring can be arranged coaxially to the recess of the housing between the support means and the outer walls to distribute the restoring force to the outer contact bodies.

For restoring a centre position of the outer contact portion the cylindrical recess within the housing can comprise a shoulder with a funnel shaped face which points substantially against the insertion direction. The guiding portion of the outer conductor can be provided with a counter face with a conical shape. When the probe is disconnected, the conical face of the outer contact portion is pushed by the support means into the funnel shaped face of the housing, moving the outer contact portion into a centre position.

In a further embodiment of the invention, a ring can be arranged between the support means and the outer contact bodies to improve the contact between the support means and the contact bodies and to distribute the restoring force to the contact bodies. To facilitate manufacturing by substituting the slanted surfaces on the outer contact portion, the ring can be substantially funnel-shaped, tapering against the probe insertion direction.

To restore the position of the inner contact portion after disconnecting the probe the inner contact portion can be connected to the housing by an elastically deformable inner support means. The inner support means can be adapted to exert a restoring force on the inner contact portion and allow a movement of the inner contact portion relative to the outer contact portion in the probe insertion direction.

To improve the reliability of the electrical contact between the inner contact portion of the probe and the inner conductor of the connecting cable, the probe can comprise a substantially hollow body which receives the inner support means and electrically connects the inner conductor of the connecting cable to the inner contact portion.

The hollow body may serve as guidance, the inner contact body arranged moveable within the guidance and extending in insertion direction out of the guidance. The inner contact portion can comprise an inner guiding portion which is adapted to be moved relative to the guidance.

Further, the coaxial test probe can comprise at least one moveable inner contact body arranged between the inner support means and the inner contact portion within the hollow body. This inner contact body can be adapted to guide the restoring force from the inner support means to the inner contact portion. By arranging the inner contact body on a slanted surface on the inner contact portion, the outer contact body is pushed by the restoring force from the inner support means against the inner wall of the hollow body. An electrically conductive connection between the inner contact portion and the hollow body is created and the hollow body connects the inner contact portion electrically to the inner conductor of the connecting cable of the probe. Thereby, the use of the support means which may have a high resistance value as outer conductor is avoided.

In a further advantageous embodiment, the outer contact portion may comprise an inner guiding recess wherein the inner contact portion is arranged moveable. To allow for a sliding movement of the inner contact portion in insertion direction, the inner contact portion can be mechanically connected to at least one inner guiding element which is arranged moveable within the guiding recess of the outer contact portion. This allows for a compensation of a misalignment in insertion direction.

In order to allow for pivoting of the inner contact portion according to at least one rotation axis which lies substantially perpendicular to the probe insertion direction the surface of the inner guiding element of the inner contact portion which abuts the inner surface of the inner guiding recess can have a convex shape. The inner guiding portion can comprise spherical surfaces and, in combination with a cylindrical inner guiding recess, build up a moveable spherical joint.

The inner contact portion may be received simultaneously by the guidance and the inner guiding recess within the outer contact portion. The guidance may be fixed to the housing. To allow for pivoting of the inner contact portion in relation to the guidance, the inner contact portion can consist of two separate parts. One part of the inner contact portion can be arranged moveable within the guidance and serve as a plunger, transmitting the restoring force from the inner support means to the second part of the inner contact portion and building up the electrical contact. The second part can be arranged moveable within the inner guiding recess, building up the electrical contact between the coaxial connector and the probe.

In a further advantageous embodiment, the housing may comprise a screw thread for mounting the housing on an adaptor plate of the testing device by arranging this screw thread directly on the cylindric outer surface of the housing no flange is needed to fix the probe to the testing device and the probe can be further minimized.

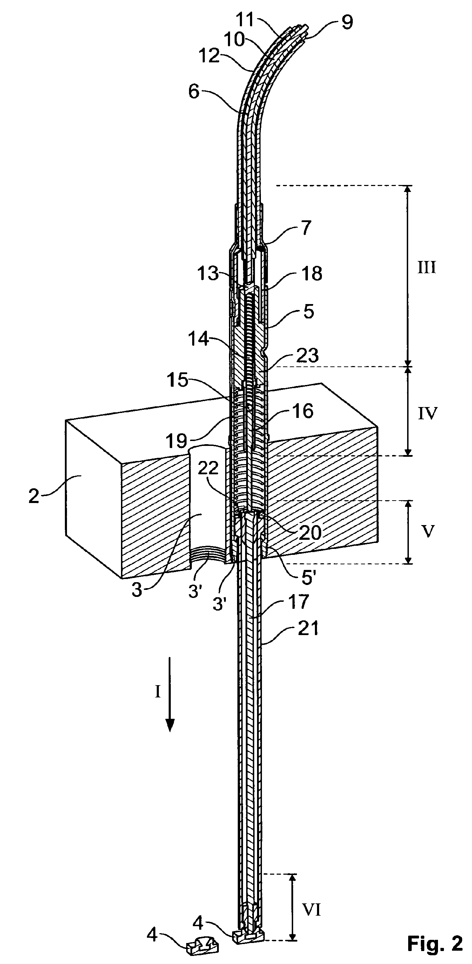

In order that the invention and its various other preferred features may be understood more easily, some embodiments thereof will now be described, by way of example only, with reference to the drawings in which:
Fig. 1
   shows the first embodiment of the coaxial probe:
Fig. 2
   shows a cross-sectional view of the first embodiment of the coaxial probe;
Fig. 3
   shows an enlarged cross-sectional view of section III of the embodiment according to Fig. 2;
Fig. 4
   shows an enlarged cross-sectional view of section IV of the embodiment according to Fig. 2;
Fig. 5
   shows an enlarged cross-sectional view of section V of the embodiment according to Fig. 2;
Fig. 6
   shows an enlarged cross-sectional view of section VI of the embodiment according to Fig. 2.

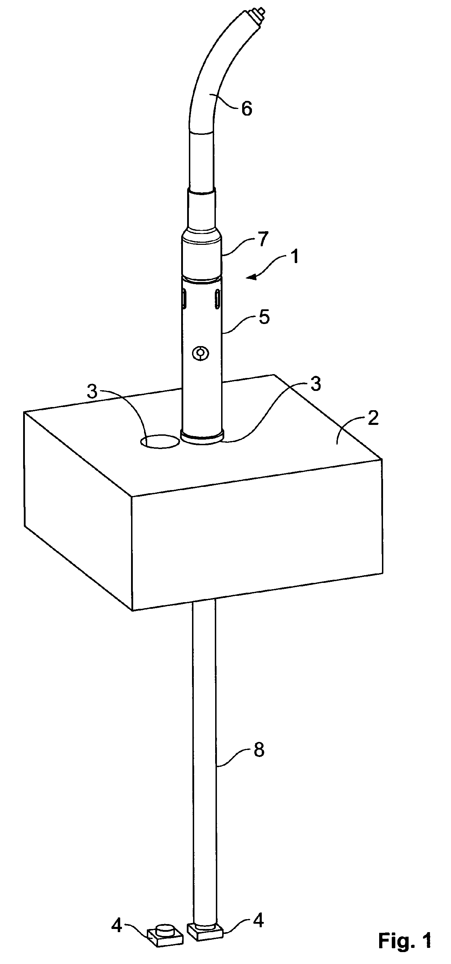

A preferred embodiment of the invention will now be described with reference to Fig. 1.

The coaxial probe 1 is mounted onto an adapter plate 2, which belongs to a test device for testing printed circuit boards (PCB) and components mounted on the PCB. For connecting the probe to the adapter plate 2 the adaptor plate 2 comprises an insertion opening 3. To connect the coaxial probe 1 electrically to the PCB assembly a coaxial connector 4 is arranged on the PCB.

The probe 1 comprises an elongated housing 5, on which a connecting cable 6 is mounted by a ferrule 7. The housing 5 is screwed into the adapter plate by a not shown screw thread. An insertion portion 8 or contact portion 8 of the probe 1 extends from the housing 5 to the coaxial connector 4 arranged on the PCB.

Fig. 2 is a cross-sectional view of the embodiment of the present invention. The adapter plate comprises insertion openings 3 with screw threads 3'. The housing 5 is screwed into the adapter plate 2 by an screw thread 5' arranged on the housing 5.

The connecting cable 6 comprises an outer conductor 9 and an inner conductor 10. An inner sheet 11 of electrically insulating material encloses the inner conductor 10 as an outer sheet 12 of insulating material encloses the outer conductor 9. The outer conductor 9 of the cable 6 is connected to the outer conductor of the probe 1 and the inner conductor 10 of the cable 6 is connected to the inner conductor of the probe 1.

The inner conductor of the probe 1 comprises a substantially cylindrical guidance 13, an inner support means 14, an inner contact body 15, and an inner contact portion 17 comprising a plunger 16. The inner support means 14 is formed as a spiral spring 14, the inner contact body 15 as a ball 15. The inner conductor 10 of the connecting cable abuts the guidance 13 and thereby is electrically connected to the inner conductor of the probe 1. The inner support means 14 is arranged within a cylindrical recess of the guidance 13. The preloaded inner support means 14 exerts a restoring force onto the inner contact body 15 which transmits the restoring force onto the plunger 16.

The plunger 16 extends through an opening at the end of the guidance 13 pointing in insertion direction I and abuts on the adjacent second part of the inner contact portion 17. The restoring force from the inner support means 14 is guided via the plunger 16 to the inner contact portion 17 and the inner contact portion 17 is pressed in insertion direction I onto the coaxial connector 4.

The outer conductor of the probe 1 comprises an outer ferrule 7, an inner ferrule 18, the housing 5, a support means 19, outer contact bodies 20, an outer contact portion 21 and a ring 22. The outer support means 19 is formed as a spiral spring 19, the outer contact bodies 20 as balls 15. The outer conductor 9 of the connecting cable 6 is electrically connected to the housing 5 via the inner ferrule 18. The portion of the outer ferrule 7, which encloses the inner ferrule 18 presses the section of the outer conductor 7, which is arranged between the outer ferrule 7 and the inner ferrule 18 onto the inner ferrule 18.

The inner ferrule 18 is mechanically connected to the housing 5 by a form closure. The inner ferrule 18 abuts an anchoring element 22, which is also mechanically connected to the housing 5 by a form closure. The anchoring element 22 supports the support means 19 by a face which substantially points to insertion direction I. The support means 19 exerts a restoring force in insertion direction I via the ring 22 on the outer contact portion 21 and thereby on the outer contact portion 21. Hence, the support means 19 pushes the outer contact portion 21 onto the outer contact of the coaxial connector 4.

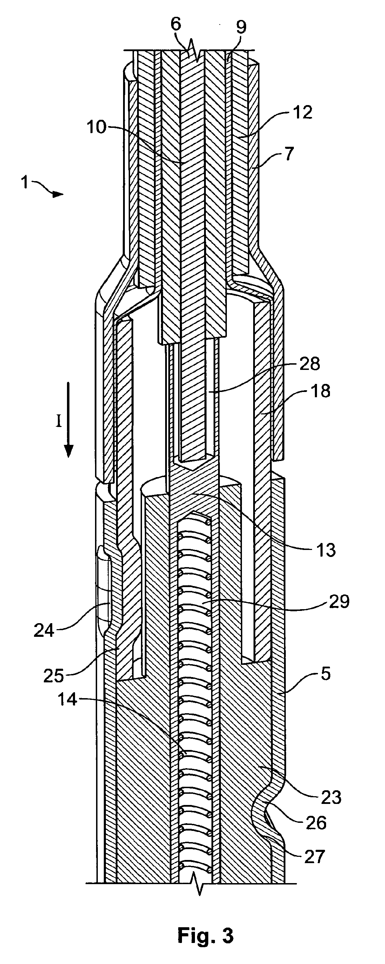

Fig. 3 shows an enlarged cross-sectional view of section III of Fig. 2, and the same reference numerals have been used.

The probe 1 is electrically connected to a connecting cable 6. The connecting cable 6 is mounted to the probe 1 by the outer ferrule 7 which encompasses the outer sheet 12 of the cable 6 and the inner ferrule 18. The ferrule 7 has two cylindrical sections with different diameters interconnected by a conical section. Within the cylindrical section, which possesses the smaller diameter, the outer sheet 12 of the connecting cable abuts the inner cylindrical surface of the outer ferrule 7. Within the conical section of the ferrule 7 the cable 6 is split up. The outer conductor 9 is widened and expands over the inner ferrule 18. The inner surface of the cylindrical section of the outer ferrule 7 with the bigger diameter abuts the outer conductor 9 of the cable 6 and presses it onto the outer surface of the cylindrical inner ferrule 18. Thereby, the outer conductor 9 is electrically connected to the inner ferrule 18. The inner ferrule 18 is electrically and mechanically connected to the housing 5.

To fasten the inner ferrule 18 the housing 5 and the inner ferrule 18 are crimped together so that a crimped area 24 of the housing 5 lies within a crimped area 25 of the inner ferrule 18. The housing 5 and the inner ferrule 18 comprise three crimped areas 24, 25, however, only two are shown. The crimped areas 24, 25 are positioned around the probe 1 with an angle of about 120° between two crimped areas 24, 25. In insertion direction I the inner ferrule 18 abuts the anchoring element 23. Also, the anchoring element 23 is fixed to the housing 5 by a form closure. Therefore, the housing 5 is provided with a further crimped area 26. The inner surface of the crimped area 26 lies against a dent 27 within the outer surface of the anchoring element 23. The anchoring element 23 can be made of elastic material, receiving the crimped area 26 of the housing by elastic deformation. For insulating the inner conductor of the probe 1 electrically from the outer conductor of the probe 1 the anchoring element 23 consists of insulating material.

The inner conductor 10 of the connecting cable 6 extends into a cylindrical bore 28 within the guidance 13. The end of the inner conductor 10 facing to probe insertion direction I abuts on the funnel shaped bottom of the bore 28. Thereby, the inner connector is electrically connected to the guidance 13. Adjacent to the bottom of the bore 28, the guidance 13 is provided with a hollow region 29 wherein the inner support means 14 is arranged. The inner support means 14 is supported by the funnel shaped end of the hollow region 29, which points against probe insertion direction I. The guidance 13 extends in insertion direction I through the anchoring element 23.

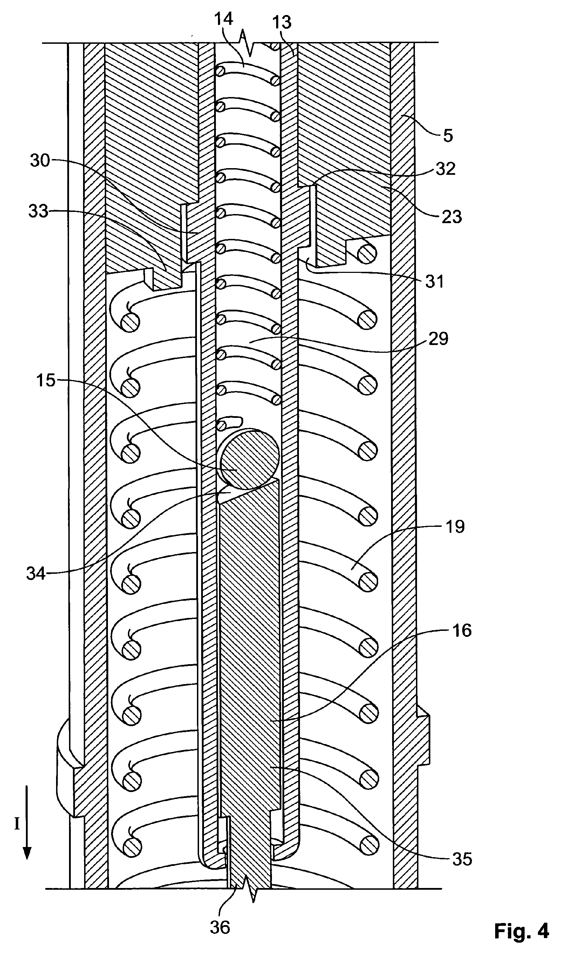

Fig. 4 shows an enlarged cross-sectional view of section IV of Fig. 2, and the same reference numerals have been used.

The anchoring element 23 provides support for the guidance 13 and for the support means 19. The guidance 13 comprises a shoulder 30, which is arranged within a recess 31 of the anchoring element 23. The shoulder 30 is supported by a step 32 within the recess 31. At the end directed into insertion direction I the anchoring element 23 is provided with an extension 33, which serves as centering 33 for the support means 19.

The inner support means 14 exerts a restoring force onto the inner contact body 15, by the restoring force the inner contact body 15 is pushed in insertion direction I. As the inner contact body 15 is arranged on a slanted surface 34 at the end of the plunger 16 a reaction force emerges due to the restoring force which is perpendicular to the slanted surface 34. This reaction force has a component parallel to the insertion direction I and a component which is directed perpendicular to the insertion direction I. The component of the reaction force, which is perpendicular to the insertion direction I, pushes the inner contact body 15 against the inner surface of the hollow region 29.

Due to the inner contact body 15 bedded on the slanted surface 34, a reliable electrical connection between the inner conductor 10 of the cable 6 and the inner contact portion 17 is assured. As the inner support means 14 possibly has a too high resistance value the electrical connection is built up via the guidance 13. The inner contact body 15, which is made of electrically conductive material electrically connects the plunger 16 to the guidance 13.

The plunger 16 consists of two sections with different diameters. Section 35, which abuts the inner contact body 15 has a bigger diameter than the section 36 which extends in insertion direction I out of the guidance 13. An inner guiding portion 35, formed as a guiding piston 35, slides within the hollow region 29 and guides the section 36, formed as a rod 36, in insertion direction I. To avoid that the guiding piston 35 leaves the hollow region 29 in insertion direction I the face of the guiding piston 35 pointing to insertion direction hits a shoulder 37 surrounding the rod 36, serving as catch 37.

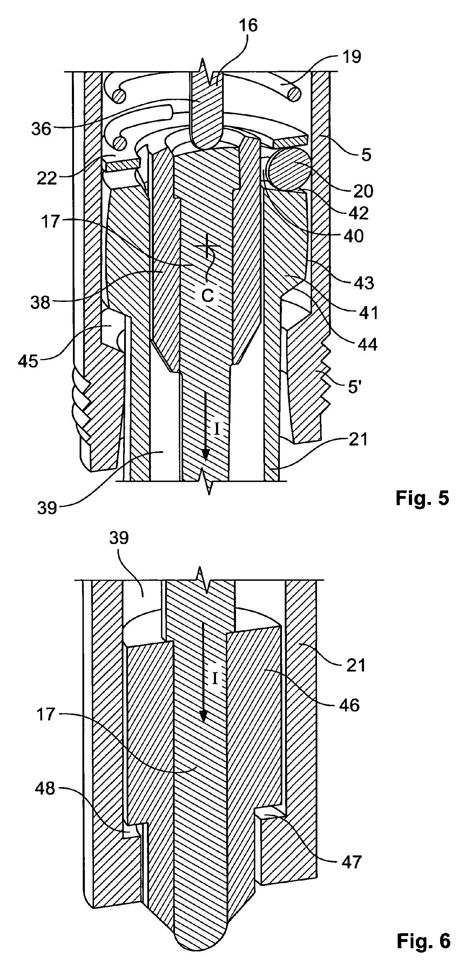

Fig. 5 shows an enlarged view of section V of Fig. 2 and illustrates the bearing of the outer contact portion 21 within the housing 5. The same reference numerals have been used.

The rod 36 of the plunger 16 abuts the inner contact portion 17. To allow for pivoting of the inner contact portion 17 in relation to the rod 36 the end of the rod 36 pointing in insertion direction is rounded and the contact face of the inner contact portion 17 pointing against insertion direction I is curved. The inner contact portion 17 is inserted into an inner guiding element 38, which slides in probe insertion direction I within an inner guiding recess 39 in the outer contact portion 21. To facilitate inserting the inner contact portion 17 into the inner guiding element 38 the opening of the concentric bore within the inner guiding element 38, which points against insertion direction I is chamfered. To facilitate inserting the inner guiding element 38 into the cylindrical inner guiding recess 39 the opening of the recess 39 pointing against insertion direction and the face of the inner guiding element 38 pointing in insertion direction are chamfered.

The support means 19 exerts a restoring force which is parallel to insertion direction via the ring 22 on the outer contact bodies 20. The outer contact portion 21 comprises a guiding portion 41 at its proximal end facing the housing 5. The outer contact bodies 20 are arranged in notches 40 within the guiding portion 41. The notches 40 comprise inclined surfaces 42. Under pressure exerted by the support means through the ring 22, the outer contact bodies 20 are pressed against the inclined surfaces 42 whereby, a reaction force, which is directed perpendicular to the inclined surface 42 is created. This reaction force has a component perpendicular to the insertion axis I, directed to the outside of the probe 1, which presses the outer contact bodies 20 against the inner wall of the electrically conductive housing 5. Thereby, the outer contact portion 21 is electrically connected to the outer conductor 9 of the connecting cable 6 via the housing 5.

To allow for pivoting of the outer contact portion 21 relative to the housing 5, the guiding portion 41 of the outer contact portion 21 is provided with convex surfaces 43. The convex 43 rolls on the inner cylindrical surface of the housing 5 and enable the outer contact portion 21 to rotate around the centre C of the guiding portion 41. The guiding portion 41 in combination with the guiding recess 49 builds up a spherical joint.

While unmating the probe the outer contact portion 21 is moved into a rest position in which the longitudinal axis of the outer contact portion 41 is aligned to the longitudinal centre axis of the housing 5. This is realized by a conical shaped surface 44 at the guiding portion 41. In unmated state of the probe 5 the outer contact portion 21 is pushed in insertion direction I by the support means 19 and the conical surface 44 rests on the funnel shaped surface 45, holding the outer contact portion 21 in the centre position.

Fig. 6 shows an enlarged view of section VI of Fig. 2, and the same reference numerals have been used.

The inner contact portion 17 is mechanically connected to an inner guiding element 46, which guides the inner contact portion 17 within the inner guiding recess 39 within the outer contact portion 21. The inner guiding element 46 is made of non-conductive material, for example plastic, insulating the inner contact portion 17 against the outer contact portion 21. The inner guiding element 46 comprises a shoulder 47. In unmated state the shoulder 47 abuts against a shoulder 48 within the inner guiding recess 39.

The end of the inner contact portion 17 pointing in insertion direction is rounded and encompassed by a concentric, conical shaped portion of the inner guiding element 46. As the coaxial connector 4 is provided with a funnel shaped mating face the conical shape of the inner guiding element 46 effects a centering of the inner contact portion 17 within the mating face of the coaxial connector 4.

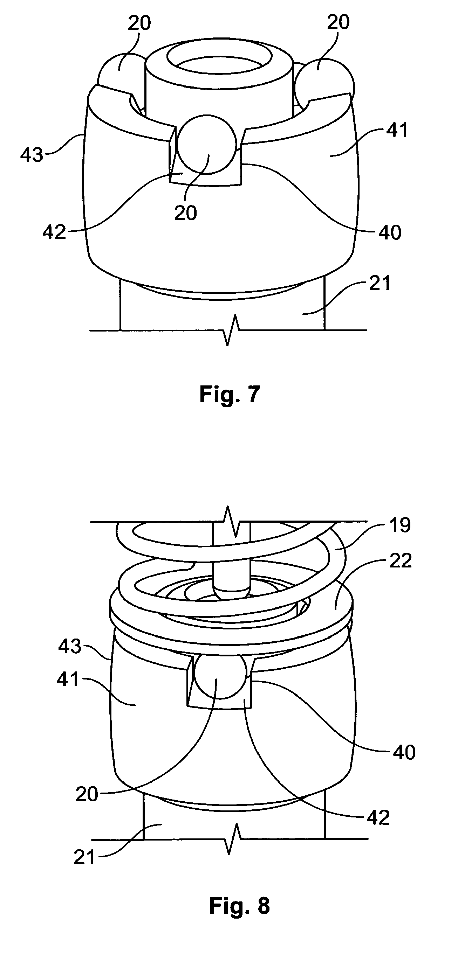

Fig. 7 shows an enlarged view of the guiding portion 41 of the outer contact portion 21, and the same reference numerals have been used.

The guiding portion 41 comprises three notches 40 with inclined surfaces 42 for supporting the outer walls 20. Alternatively, the principle can be realized with more or less than three outer contact bodies 20. Even one outer contact body 20 can suffice to realize a reliable electrical contact between the outer contact portion 21 and the housing 5.

Fig. 8 shows a further detailed view of the guiding portion 41 of the outer contact portion 21 , and the same reference numerals have been used.

A ring 22 distributes the restoring force from the support means 19 to the outer contact bodies 20. The outer contact bodies 20 are pushed onto the inclined surfaces 42 of the notches 40 and thereby towards the not shown inner wall of the housing, providing the contact force for the electrical contact and a reliable electrical connection. By arranging the outer contact bodies 20 around the centre axis of the outer contact portion 21, the space in the centre of the outer contact portion 21 can be used for introducing the moveable inner contact portion 17.

The slanted or inclined surfaces 42 of the notches 40 can alternatively be horizontal or perpendicular to the insertion direction I. Then the ring 22 may be used for pushing the outer contact bodies against the inner wall of the housing 5 by providing the ring 22 with slanted surfaces or by providing the ring 22 with a conical shape.

## Claims

1. Coaxial probe (1) for mating with a coaxial connector (4), said coaxial connector (4) mounted on a printed circuit board, the coaxial probe (1) comprising:
a housing (5),
an outer contact portion (21), said outer contact portion (21) extending away from the housing (5) in a probe insertion direction (I),
an inner contact portion (17), said inner contact portion (17) being adapted to be moved in the probe insertion direction (I) relative to the housing (5),
said housing (5) supporting both the inner and outer contact portion (21),
**characterized in that**
the outer contact portion (21) is connected to the housing (5) by an elastically deformable support means (19), said support means (19) being adapted to allow a movement of the outer contact portion (21) relative to the housing (5) in the probe insertion direction.

2. Coaxial probe (1) according to claim 1, **characterized in that** said support means (19) is adapted to allow a deflection of the outer contact portion (21) relative to the housing (5) in a direction substantially perpendicular to the probe insertion direction (I).

3. Coaxial probe (1) according to claim 1 or 2, **characterized in that** said support means (19) is adapted to generate a restoring force upon deformation.

4. Coaxial probe (1) according to one of the claims 1 to 3, **characterized in that** the housing (5) comprises a substantially hollow guiding recess (49) and that the outer contact portion (21) comprises a guiding portion (41) at its proximal end facing the housing, said guiding portion (41) being received within the guiding recess (49) of the housing (5) and being adapted to be moved relative to the guiding recess (49).

5. Coaxial probe (1) according to claim 4, **characterized in that** the surface of the guiding portion (41) of the outer contact portion (21) which abuts to the inner surface of the guiding recess (49) has a convex shape.

6. Coaxial probe (1) according to one of the claims 1 to 5, **characterized in that** the coaxial probe (1) comprises at least one moveable outer contact body (20), said outer contact body (20) arranged between the support means (19) and the outer contact portion (21), said outer contact body (20) being arranged to guide the restoring force from the support means (19) to the outer contact portion (21).

7. Coaxial probe (1) according to claim 6, **characterized in that** the outer contact portion (21) comprises at its end pointing against the probe insertion direction (I) at least one inclined surface (42) forming an angle with the probe insertion direction (I), the outer contact body (20) is arranged on the inclined surface (42) and abuts the inner surface of the guiding recess (49).

8. Coaxial probe (1) according to one of the claims 4 to 7, **characterized in that** the housing (5) comprises a funnel-shaped face (45), the funnel-shaped face (45) pointing substantially against the probe insertion direction (I) and being arranged coaxially to the guiding recess (49), and that the guiding portion (41) of the outer contact portion (21) is provided with a conical face (44), wherein in an unmated state of the probe (1) the conical face (44) abuts the funnel-shaped face (45).

9. Coaxial probe (1) according to one of the claims 6 to 8, **characterized in that** the probe (1) comprises at least one ring (22), said ring (22) being arranged coaxially to the guiding recess (49) between the support means (19) and the outer contact body (20), guiding the restoring force from the support means (19) to the outer contact body (20).

10. Coaxial probe (1) according to claim 9, **characterized in that** the ring (22) is substantially funnel-shaped, tapering against the probe insertion direction.

11. Coaxial probe (1) according to one of the claims 1 to 10, **characterized in that** the inner contact portion (17) is connected to the housing (5) by an elastically deformable inner support means (14), said inner support means (14) being adapted to exert a restoring force on the inner contact portion (17) and to allow a movement of the inner contact portion (17) relative to the outer contact portion (21) in the probe insertion direction (I).

12. Coaxial probe (1) according to one of the claims 1 to 11, **characterized in that** the outer contact portion (21) comprises an inner guiding recess (39) and that the inner contact portion (17) comprises at least one inner guiding element (38), said inner guiding element (38) being received within the inner guiding recess (39) of the outer contact portion (21) and being adapted to be moved relative to the inner guiding recess (38).

13. Coaxial probe (1) according to one of the claims 11 or 12, **characterized in that** the probe (1) comprises at least one inner contact body (15), said inner contact body (15) arranged between the inner support means (14) and the inner contact portion (17), said inner contact body (15) being arranged to guide the restoring force from the inner support means (14) to the outer contact portion (21).

14. Coaxial probe (1) according to one of the claims 11 to 13, **characterized in that** the coaxial probe (1) comprises a guidance (13), said guidance (13) having a substantially hollow region (29), the inner contact body (15) and the inner support means (14) being arranged moveable within the inner hollow region (29).

15. Coaxial probe (1) according to claim 14, **characterized in that** the inner contact portion (17) comprises an inner guiding portion (35), said inner guiding portion (35) being received within the hollow region (29) of the guidance (13) and being adapted to be moved relative to the guidance (13).
